# EUROPÄISCHE PATENTSCHRIFT

(11) **EP 2 474 203 B1**
(45) Veröffentlichungstag und Bekanntmachung des Hinweises auf die Patenterteilung: **02.08.2017**
(21) Anmeldenummer: 10740673.8
(22) Anmeldetag: 10.08.2010
(51) Int. Cl.: C09K 11/08, H01L 33/50

(54) **KONVERSIONSMITTELKÖRPER, OPTOELEKTRONISCHER HALBLEITERCHIP UND VERFAHREN ZUR HERSTELLUNG EINES OPTOELEKTRONISCHEN HALBLEITERCHIPS**
CONVERSION AGENT BODY, OPTOELECTRONIC SEMICONDUCTOR CHIP, AND METHOD FOR PRODUCING AN OPTOELECTRONIC SEMICONDUCTOR CHIP
CORPS DE MOYEN DE CONVERSION, PUCE SEMICONDUCTRICE OPTOÉLECTRONIQUE ET PROCÉDÉ DE FABRICATION D'UNE PUCE SEMICONDUCTRICE OPTOÉLECTRONIQUE

(30) Priorität: 04.09.2009 DE 102009040148
(43) Veröffentlichungstag der Anmeldung: 11.07.2012
(73) Patentinhaber: OSRAM Opto Semiconductors GmbH, 93055 Regensburg (DE)
(72) Erfinder: BRAUNE, Bert, 93173 Wenzenbach (DE)
(74) Vertreter: Epping - Hermann - Fischer
(86) Internationale Anmeldenummer: PCT/EP2010/061648
(87) Internationale Veröffentlichungsnummer: WO 2011/026716

(56) Entgegenhaltungen:
- EP-A1- 2 043 165
- WO-A2-2007/127029
- WO-A2-2009/119038
- US-A1- 2008 048 200

## Beschreibung

Es wird eine Anordnung mit einem Konversionsmittelkörper angegeben. Darüber hinaus wird ein Verfahren zur Herstellung eines optoelektronischen Halbleiterchips angegeben.

In der Druckschrift EP 2 043 165 A1 ist eine Beleuchtungsvorrichtung angegeben.

Die Druckschrift US 2008/0048200 A1 betrifft eine LED mit einem Leuchtstoff und mit einer übergespritzten Linse.

Ein Verfahren zur Herstellung von geformten Harzteilen findet sich in der Druckschrift WO 2009/119038 A2.

Die Beschreibung einer seitlich emittierenden, oberflächenmontierbaren Leuchtdiode ist in der Druckschrift WO 2007/127029 A2 wiedergegeben.

Eine zu lösende Aufgabe besteht darin, einen Konversionsmittelkörper anzugeben, der ein hohes Haftungsvermögen an einer Halbleiterschichtenfolge aufweist. Weiterhin besteht eine zu lösende Aufgabe darin, ein Verfahren zur Herstellung eines optoelektronischen Halbleiterchips anzugeben.

Diese Aufgaben werden durch eine Anordnung und durch ein Verfahren mit den Merkmalen der unabhängigen Patentansprüche 1 und 11 gelöst.

Gemäß zumindest einer Ausführungsform des Konversionsmittelkörpers ist dieser dafür vorgesehen, an einem optoelektronischen Halbleiterchip angebracht zu werden. Bei dem Halbleiterchip kann es sich um eine Fotodiode, um eine Laserdiode oder, bevorzugt, um eine Leuchtdiode handeln. Insbesondere weist der Konversionsmittelkörper geometrische Abmessungen auf, die mit denen des Halbleiterchips vergleichbar sind. Beispielsweise beträgt eine mittlere laterale Abmessung des Halbleiterchips und/oder des Konversionsmittelkörpers zwischen einschließlich 0,3 mm und 10,0 mm, insbesondere zwischen einschließlich 0,5 mm und 3,0 mm.

Gemäß zumindest einer Ausführungsform des Konversionsmittelkörpers umfasst dieser ein Matrixmaterial und Konversionsmittelpartikel, die in das Matrixmaterial eingebettet sind. Es können hierbei eine Art oder mehrere verschiedene Arten von Konversionsmittelpartikeln Verwendung finden.

Gemäß zumindest einer Ausführungsform des Konversionsmittelkörpers ist das Matrixmaterial unvollständig ausgehärtet und/oder unvollständig vernetzt. Mit anderen Worten ist eine Härte und/oder ein Elastizitätsmodul des Matrixmaterials durch einen weiteren Aushärteprozess oder Vernetzungsprozess steigerbar.

Gemäß zumindest einer Ausführungsform des Konversionsmittelkörpers weist dieser bei Raumtemperatur eine Härte zwischen einschließlich Shore A 0 und Shore A35 oder zwischen einschließlich Shore A 2 und Shore A 15 und/oder eine Viskosität zwischen einschließlich 10,0 Pa·s und 150 Pa·s oder zwischen einschließlich 15,0 Pa·s und 70 Pa·s auf. Mit Raumtemperatur ist insbesondere eine Temperatur von zirka 293 K gemeint. Der Konversionsmittelkörper mit dem unvollständig ausgehärteten und/oder vernetzten Matrixmaterial ist also vergleichsweise weich.

In mindestens einer Ausführungsform des Konversionsmittelkörpers, der für einen optoelektronischen Halbleiterchip vorgesehen ist, umfasst dieser ein Matrixmaterial und Konversionsmittelpartikel, die in das Matrixmaterial eingebettet sind. Das Matrixmaterial ist dabei unvollständig ausgehärtet und/oder unvollständig vernetzt und der Konversionsmittelkörper zeigt bei Raumtemperatur eine Härte zwischen einschließlich Shore A 10 und Shore A 35 und/oder eine Viskosität zwischen einschließlich 10 Pa·s und 70 Pa·s auf.

Der Konversionsmittelkörper ist in dem unvollständig ausgehärteten und/oder vernetzten Zustand auf einer Halbleiterschichtenfolge formschlüssig anbringbar. Durch ein nachfolgendes Aushärten des Konversionsmittelkörpers ist eine besonderes feste mechanische Verbindung zwischen dem Konversionsmittelkörper und der Halbleiterschichtenfolge erzielbar. Hierdurch ist eine Lebensdauer des Halbleiterchips verlängerbar.

Gemäß zumindest einer Ausführungsform des Konversionsmittelkörpers umfasst das Matrixmaterial ein Silikon oder besteht aus einem solchen. Ebenso ist es möglich, dass das Matrixmaterial ein Epoxid oder ein Silikon-Epoxid-Hybridmaterial umfasst oder hieraus besteht.

Gemäß zumindest einer Ausführungsform des Konversionsmittelkörpers ist dieser frei von einem Thixotropiermittel. Es hat sich herausgestellt, dass insbesondere durch die Verwendung von langkettigen Grundstoffen für ein Silikon und/oder eines hoch viskosen Ausgangsmaterials für das Matrixmaterial ein Entmischen und/oder ein Absinken der Konversionsmittelpartikel im unausgehärteten Matrixmaterial verhinderbar ist. Hierdurch ist ein insbesondere als Partikel, speziell Nanopartikel, vorliegendes Thixotropiermittel entbehrbar.

Gemäß zumindest einer Ausführungsform des Konversionsmittelkörpers beträgt ein Gewichtsanteil der Konversionsmittelpartikel zwischen einschließlich 20 % und 75 %, bevorzugt zwischen einschließlich 55 % und 70 %. Mit anderen Worten ist ein erheblicher Gewichtsanteil des Konversionsmittelkörpers von den Konversionsmittelpartikeln verursacht.

Gemäß zumindest einer Ausführungsform des Konversionsmittelkörpers ist dieser einstückig geformt. Das heißt, das Matrixmaterial bildet eine zusammenhängende, ununterbrochene Einheit, in der die Konversionsmittelpartikel eingebettet sind. Insbesondere weist der Konversionsmittelkörper dann keine Teilbereiche mit einer Vielzahl von Konversionsmittelpartikeln auf, die etwa durch Phasengrenzen voneinander abgegrenzt sind und/oder die sich in einer mittleren Materialzusammensetzung und/oder in einer physikalischen Eigenschaft voneinander unterscheiden.

Darüber hinaus wird ein optoelektronischer Halbleiterchip angegeben, der beispielsweise einen Konversionsmittelkörper gemäß einer oder mehrerer der oben genannten Ausführungsformen umfasst. Merkmale des Konversionsmittelkörpers sind daher auch für den hier beschriebenen optoelektronischen Halbleiterchip offenbart und umgekehrt.

Der optoelektronische Halbleiterchip umfasst eine Halbleiterschichtenfolge mit mindestens einer aktiven Schicht. Ferner beinhaltet der Halbleiterchip einen einstückigen Konversionsmittelkörper mit einem Matrixmaterial, in das Konversionsmittelpartikel eingebettet sind. Der Konversionsmittelkörper steht hierbei in direktem Kontakt mit der Halbleiterschichtenfolge und ist weiterhin verbindungsmittelfrei auf der Halbleiterschichtenfolge aufgebracht. Eine Härte des Konversionsmittelkörpers beträgt mindestens Shore A 30 und höchstens Shore D 80, bevorzugt mindestens Shore A 60 und höchstens Shore D 80, insbesondere mindestens Shore D 30 und höchstens Shore D 75.

Verbindungsmittelfrei kann bedeuten, dass sich zwischen der Halbleiterschichtenfolge und dem Konversionsmittelkörper kein Verbindungsmittel wie ein Kleber, eine Klebefolie oder ein Lot befindet. Dass die Halbleiterschichtenfolge und der Konversionsmittelkörper wenigstens stellenweise in direktem Kontakt zueinander stehen kann bedeuten, dass das Matrixmaterial mindestens stellenweise in physischem Kontakt zu einem Halbleitermaterial der Halbleiterschichtenfolge steht.

Elektrische Kontaktstrukturen, die zum Beispiel direkt auf einem Halbleitermaterial der Halbleiterschichtenfolge aufgebracht sind, können hierbei als zur Halbleiterschichtenfolge gehörig zu zählen sein, falls die Kontaktstrukturen unmittelbar, fest, dauerhaft und/oder integral mit dem Halbleitermaterial verbunden sind. Das heißt, in direktem Kontakt mit der Halbleiterschichtenfolge kann auch bedeuten, dass der Konversionsmittelkörper auf solchen elektrischen Kontaktstrukturen, die beispielsweise mit einem Metall oder einem transparenten leitfähigen Oxid geformt sind, unmittelbar aufgebracht ist.

Es sind eine Strahlungsdurchtrittsfläche und Flanken der Halbleiterschichtenfolge zum Beispiel jeweils zu mindestens 90 % von dem Konversionsmittelkörper überdeckt. Der Überdeckungsgrad ist insbesondere in eine Richtung senkrecht zu den jeweiligen Flächen der Halbleiterschichtenfolge zu bestimmen.

Es liegt der Konversionsmittelkörper zum Beispiel an wenigstens einer Begrenzungsfläche der Halbleiterschichtenfolge formschlüssig an. Das bedeutet, insbesondere auf einer mikroskopischen Skala schmiegen sich der Konversionsmittelkörper und die Begrenzungsfläche aneinander an. Speziell können Aufrauungen der Halbleiterschichtenfolge von dem Konversionsmittelkörper an der Begrenzungsfläche nachgebildet sein. Hierdurch kann insbesondere auf mikroskopischer Skala eine Verzahnung zwischen der Halbleiterschichtenfolge und dem Konversionsmittelkörper resultieren, wodurch eine besonders hohe Haftung zwischen Konversionsmittelkörper und Halbleiterschichtenfolge erzielbar ist. Ebenso vergrößert sich eine Kontaktfläche zwischen der Halbleiterschichtenfolge und dem Konversionsmittelkörper, so dass auch die Haftvermittlung über Adhäsionskräfte zunimmt. Eine der Begrenzungsfläche des Halbleiterkörpers abgewandte Seite des Konversionsmittelkörpers kann hierbei glatt oder eben ausgebildet sein, so dass zum Beispiel die Aufrauung an dieser Seite nicht nachgebildet ist.

Es sind Flanken des Halbleiterchips, also laterale Begrenzungsflächen insbesondere parallel zu einer Wachstumsrichtung des Halbleiterchips, zum Beispiel zu höchstens 15 % oder zu höchstens 5 % von dem Konversionsmittelkörper bedeckt, in eine Richtung senkrecht zu den Flanken. Insbesondere sind die Flanken von dem Konversionsmittelkörper unbedeckt.

Ferner wird ein Verfahren zur Herstellung eines optoelektronischen Halbleiterchips angegeben. Merkmale des Konversionsmittelkörpers sowie des optoelektronischen Halbleiterchips sind auch für das hier beschriebene Verfahren offenbart und umgekehrt.

In mindestens einer Ausführungsform des Verfahrens umfasst dieses die Schritte:
- Bereitstellen einer Halbleiterschichtenfolge mit mindestens einer aktiven Schicht,
- Bereitstellen eines einstückigen Konversionsmittelkörpers mit einem Matrixmaterial, in das Konversionsmittelpartikel eingebettet sind, wobei das Matrixmaterial unvollständig vernetzt und/oder ausgehärtet ist, und wobei der Konversionsmittelkörper bei Raumtemperatur eine Härte zwischen einschließlich Shore A 0 und Shore A 35 und/oder eine Viskosität zwischen einschließlich 10 Pa·s und 150 Pa·s aufweist,
- Aufbringen des Konversionsmittelkörpers auf die Halbleiterschichtenfolge, so dass diese in direktem Kontakt zueinander stehen,
- Aushärten des Konversionsmittelkörpers, wobei nach dem Aushärten die Härte des Konversionsmittelkörpers mindestens Shore A 30 und höchstens Shore D 80 beträgt, und
- Fertigstellen des optoelektronischen Halbleiterchips.

Gemäß zumindest einer Ausführungsform des Verfahrens ist der Konversionsmittelkörper auf einer Trägerfolie aufgebracht und von einer Abdeckfolie überdeckt. Mit anderen Worten befindet sich der Konversionsmittelkörper zwischen der Trägerfolie und der Abdeckfolie. Wenigstens die Abdeckfolie lässt sich von dem Konversionsmittelkörper zerstörungsfrei entfernen, insbesondere auch so lange das Matrixmaterial des Konversionsmittelkörpers nicht vollständig ausgehärtet ist.

Gemäß zumindest einer Ausführungsform des Verfahrens lassen sich sowohl die Trägerfolie als auch die Abdeckfolie von dem Konversionsmittelkörper entfernen ohne diesen zu beschädigen, so lange das Matrixmaterial nicht vollständig ausgehärtet ist.

Gemäß zumindest einer Ausführungsform des Verfahrens ist die Trägerfolie und/oder die Abdeckfolie im ultravioletten und/oder im blauen Spektralbereich mindestens teilweise strahlungsdurchlässig. Hierdurch ist es möglich, dass das Matrixmaterial durch zum Beispiel die Trägerfolie hindurch fotochemisch vernetzbar und/oder aushärtbar ist.

Gemäß zumindest einer Ausführungsform des Verfahrens wird der Konversionsmittelkörper derart bereit gestellt, dass dieser, insbesondere mit einer Toleranz von höchstens 25 % oder von höchstens 5 %, laterale Ausdehnungen und/oder Formen des Halbleiterchips aufweist. Der Konversionsmittelkörper kann also bereits vor dem Aufbringen auf den Halbleiterchip wie eine oder näherungsweise wie eine Strahlungsdurchtrittsfläche des Halbleiterchips geformt und/oder zugeschnitten sein. Der Konversionsmittelkörper wird also insbesondere deckungsgleich mit der Strahlungsdurchtrittsfläche geformt, zum Beispiel an der Trägerfolie, und auf den Halbleiterchip aufgebracht.

Nachfolgend wird ein hier beschriebenes Bauteil sowie ein hier beschriebenes Verfahren unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figuren 1 bis 4: schematische Schnittdarstellungen von optoelektronischen Halbleiterchips,
- Figur 5: eine schematische Darstellung einer Zeitabhängigkeit eines Haftvermögens eines hier Konversionsmittelkörpers an einem optoelektronischen Halbleiterchip,
- Figuren 6 und 7: schematische Darstellung von hier beschriebenen Herstellungsverfahren für optoelektronische Halbleiterchips, und
- Figur 8: schematische Schnittdarstellungen von herkömmlichen Halbleiterbauteilen.

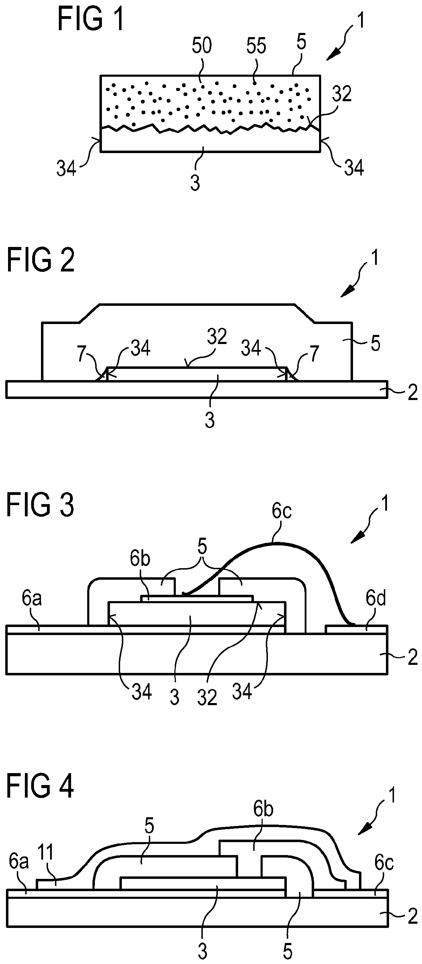

In Figur 1 ist ein optoelektronischer Halbleiterchip 1 dargestellt. Der Halbleiterchip 1 umfasst eine Halbleiterschichtenfolge 3, die mindestens eine aktive Schicht beinhaltet. Beispielsweise stellt die Halbleiterschichtenfolge 3 eine Leuchtdiode dar, die im Betrieb insbesondere ultraviolette und/oder blaue Strahlung emittiert. An einer Strahlungsdurchtrittsfläche 32 der Halbleiterschichtenfolge 3 ist eine Aufrauung erzeugt. Über die Aufrauung wird eine Lichtauskopplung aus der Halbleiterschichtenfolge 3 an der Strahlungsdurchtrittsfläche 32 erhöht. Flanken 34 stellen laterale Begrenzungsflächen der Halbleiterschichtenfolge 3 dar.

Weiterhin umfasst der Halbleiterchip 1 einen Konversionsmittelkörper 5. Der Konversionsmittelkörper 5 weist Konversionsmittelpartikel 55 auf, die in ein Matrixmaterial 50 eingebettet sind. Die Konversionsmittelpartikel 55 sind statistisch und/oder homogen in dem Matrixmaterial 50 verteilt. Über die Konversionsmittelpartikel 55 wird eine von der Halbleiterschichtenfolge 3 im Betrieb erzeugte Strahlung teilweise oder vollständig in eine Strahlung mit einer anderen Wellenlänge umgewandelt. Der Konversionsmittelkörper 5 ist bevorzugt fotochemisch stabil gegenüber einer von der Halbleiterschichtenfolge 3 emittierten Strahlung und gegenüber den im Betrieb auftretenden thermischen Belastungen.

Ein mittlerer Durchmesser der Konversionsmittelpartikel 55 liegt beispielsweise zwischen einschließlich 1 nm und 100 nm. Ebenso ist es alternativ oder zusätzlich möglich, dass ein Durchmesser der Konversionsmittelpartikel 55 oder weiterer Konversionsmittelpartikel zwischen einschließlich 1 µm und 20 µm beträgt. In den weiteren Abbildungen sind das Matrixmaterial 50 und die Konversionsmittelpartikel 55 jeweils nicht dargestellt.

Der einstückige Konversionsmittelkörper 5 schmiegt sich formschlüssig an die Aufrauung an der Strahlungsdurchtrittsfläche 32 der Halbleiterschichtenfolge 3 an. Zwischen der Aufrauung der Strahlungsdurchtrittsfläche 32 und dem Matrixmaterial 50 resultiert hieraus eine Verzahnung auf mikroskopischer Skala, wodurch eine besonders stabile Haftung zwischen der Halbleiterschichtenfolge 3 und dem Konversionsmittelkörper 5 realisierbar ist.

Der Konversionsmittelkörper 5 schließt in lateraler Richtung bündig mit den Flanken 34 der Halbleiterschichtenfolge 3 ab. Laterale Abmessungen des Konversionsmittelkörpers 5 und/oder der Halbleiterschichtenfolge 3 liegen bevorzugt zwischen einschließlich 300 µm und 3 mm, insbesondere zwischen einschließlich 500 µm und 2 mm. Eine Dicke des Konversionsmittelkörpers beträgt bevorzugt zwischen einschließlich 20 µm und 125 µm, insbesondere zwischen einschließlich 30 µm und 70 µm. Eine Dicke der Halbleiterschichtenfolge 3 beträgt bevorzugt höchstens 200 µm, insbesondere höchstens 12 µm.

Gemäß Figur 2 überragt der Konversionsmittelkörper 5 die Halbleiterschichtenfolge 3 in lateraler Richtung. Die Halbleiterschichtenfolge 3 ist hierbei auf einen Träger 2 aufgebracht. Die Halbleiterschichtenfolge 3 ist dabei von dem Träger 2, dem Konversionsmittelkörper 5 und von in Figur 2 nicht gezeichneten elektrischen Kontaktstrukturen zur elektrischen Kontaktierung der Halbleiterschichtenfolge 3 vollständig umschlossen. Dabei ist es möglich, dass sich an den Flanken 34 der Halbleiterschichtenfolge 3 ein Hohlraum 7 ausbildet.

Eine dem Träger 2 abgewandte Begrenzungsfläche des Konversionsmittelkörpers 5 weist in einem Bereich über der Strahlungsdurchtrittsfläche 32 eine linsenartige Formgebung auf. Mit anderen Worten ist eine Höhe des Konversionsmittelkörpers 5, bezogen auf den Träger 2, nicht über die gesamte laterale Ausdehnung hinweg konstant.

Gemäß Figur 3 sind elektrische Kontaktstrukturen 6a-d ausgebildet. Die Kontaktstruktur 6c, die als Bond-Draht geformt ist, durchdringt hierbei in einer Richtung senkrecht zu einer Haupterstreckungsrichtung der Halbleiterschichtenfolge 3 den einstückigen Konversionsmittelkörper 5 vollständig.

Der Konversionsmittelkörper 5 bedeckt dabei jeweils mindestens 90 % der Strahlungsdurchtrittsfläche 32 und der Flanken 34. Die elektrische Kontaktstruktur 6b ist beispielsweise auf ein Halbleitermaterial der Halbleiterschichtenfolge 3 aufgedampft.

Gemäß Figur 4 ist der direkt auf der Halbleiterschichtenfolge 3 aufgebrachte, einstückige Konversionsmittelkörper 5 vollständig von der Kontaktstruktur 6b durchdrungen, die beispielsweise über ein Aufdampfen und/oder über einen fotolithographischen Prozess erzeugt ist. Sowohl die Kontaktstruktur 6b als auch der Konversionsmittelkörper 5 sind von einer elektrischen Isolierschicht 11 vollständig überdeckt. Ein Material der Isolierschicht 5 unterscheidet sich bevorzugt von dem Matrixmaterial des Konversionsmittelkörpers 5.

Eine Härte des Konversionsmittelkörpers 5 beträgt zwischen einschließlich Shore D 45 und Shore D 80. Durch diese hohe Härte ist die Halbleiterschichtenfolge 3 durch den Konversionsmittelkörper 5 mechanisch schützbar. Außerdem ermöglicht die hohe Härte eine besonders effiziente Verzahnung und somit ein hohes Haftungsvermögen zwischen einer Strukturierung beziehungsweise Aufrauung der Strahlungsdurchtrittsfläche 32 und dem Matrixmaterial 50.

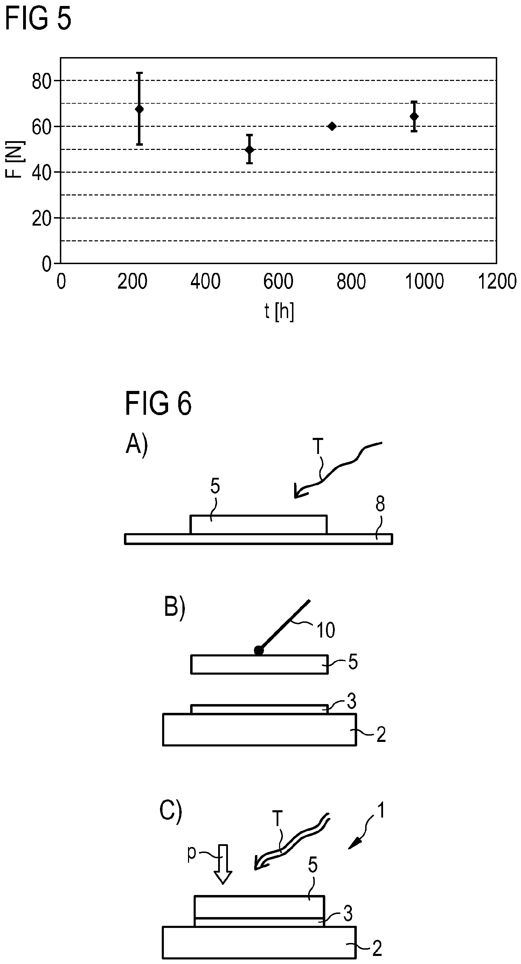

In Figur 5 ist eine Scherkraft F in Abhängigkeit von einer Zeit t eines Konversionsmittelkörpers, beispielsweise gemäß einer der Figuren 1 bis 4, an einer Halbleiterschichtenfolge 3 illustriert. Über die gesamte Zeitspanne von 1000 h liegt hierbei eine Temperatur bei 185 °C. Eine Scherkraft, bei der eine Delamination des Konversionsmittelkörpers 5 beispielsweise von einer Halbleiterschichtenfolge 3 gemäß einer der Figuren 1 bis 4 erfolgt, liegt jeweils bei mindestens 50 N.

In Figur 6 ist ein Herstellungsverfahren für den Halbleiterchip 1 illustriert. Gemäß Figur 6A wird auf einer Trägerfolie 8, die beispielsweise eine Ethylen-Tetrafluorethylen-Folie ist, über insbesondere ein Siebdruckverfahren der Konversionsmittelkörper 5 aufgebracht. Anschließend wird der Konversionsmittelkörper 5 mit dem Matrixmaterial und den Konversionsmittelpartikeln mittels einer Temperatureinwirkung T bei einer Temperatur von zirka 150 °C über eine Zeitspanne von 4 min angehärtet. Das Matrixmaterial ist hierbei zum Beispiel LPS-AF500Y des Herstellers Shin-Etsu. Durch das Anhärten weist der Konversionsmittelkörper eine Härte zwischen einschließlich Shore A 10 und Shore A 35 auf, so dass der Konversionsmittelkörper mittels eines Bestückungsautomaten 10, englisch Pick and Place Machine, auf die Halbleiterschichtenfolge aufbringbar ist, siehe Figur 6B.

Der auf der Trägerfolie 8 erzeugte Konversionsmittelkörper 5 ist in einem in Figur 6 nicht illustrierten optionalen weiteren Verfahrensschritt glättbar, so dass eine besonders gleichmäßige Dicke des Konversionsmittelkörpers 5 resultiert, und/oder in lateralen Abmessungen zuschneidbar. Hierbei ist es, anders als in Figur 6A dargestellt, auch möglich, dass die Trägerfolie 8 in lateraler Richtung bündig mit dem Halbleiterkörper 5 abschließt.

In Figur 6C ist dargestellt, dass nachfolgend das Matrixmaterial über die Temperatureinwirkung T vollständig ausgehärtet und/oder vernetzt wird. Eine Aushärtezeit beträgt bevorzugt mindestens 10 min. Zum Beispiel erfolgt das Aushärten bei einer Temperatur von 150 °C über eine Zeitspanne von 1 h. Optional kann während des gesamten oder eines Teils des thermischen Aushärtens der Konversionsmittelkörper 5 über eine Druckeinwirkung p an die Halbleiterschichtenfolge 3 angedrückt und/oder angepresst werden.

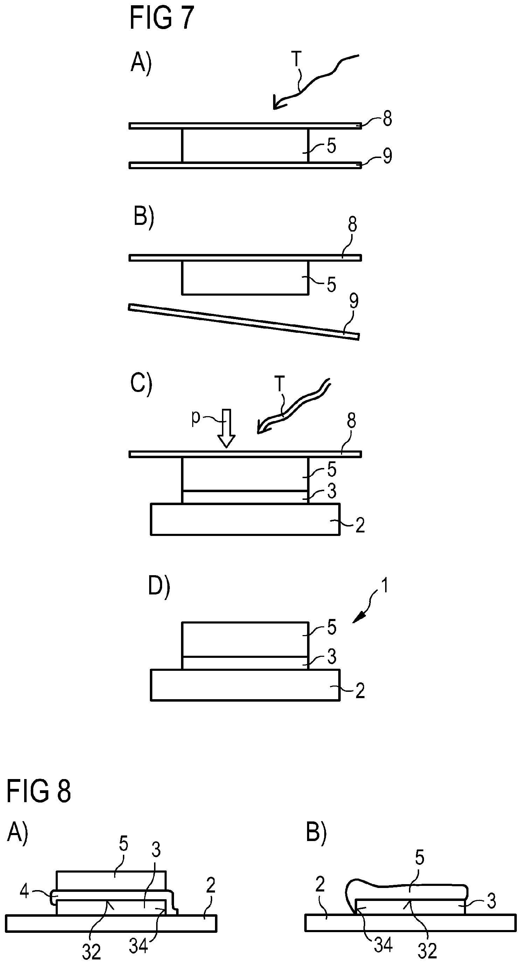

Bei dem Verfahren gemäß Figur 7 befindet sich der Konversionsmittelkörper 5 zwischen der Trägerfolie 8 und einer Abdeckfolie 9, siehe Figur 7A. Ein Anhärten des Konversionsmittelkörpers 5 erfolgt beispielsweise über eine Temperatureinwirkung T und/oder durch ultraviolette oder blaue Strahlung durch die Trägerfolie 8 hindurch. Nach dem Anhärten weist der Konversionsmittelkörper 5 nur eine geringe Härte und/oder nur eine vergleichsweise geringe Viskosität zwischen einschließlich 10 Pa·s und 70 Pa·s auf. Eine Formgebung des Konversionsmittelkörpers 5 erfolgt beispielsweise durch ein Walzen und optional durch ein nachfolgendes Vereinzeln und/oder Zuschneiden. Auch ein Stempeln oder Formpressen ist möglich, insbesondere falls der Konversionsmittelkörper 5 linsenartig geformt wird.

Gemäß Figur 7B wird nach dem Anhärten die Abdeckfolie 9 von dem Konversionsmittelkörper 5 entfernt. Hierbei verbleibt der Konversionsmittelkörper 5 an der Trägerfolie 8.

In Figur 7C ist gezeigt, dass über die Trägerfolie 8 der Konversionsmittelkörper 5 an der Halbleiterschichtenfolge 3 angebracht wird. Ein Aushärten über die Temperatureinwirkung T oder ein fotochemisches Aushärten des einstückigen Konversionsmittelkörpers 5 erfolgt bevorzugt bei gleichzeitiger Druckeinwirkung p. Die Trägerfolie 8 kann bei dem Aushärten noch an dem Konversionsmittelkörper 5 verbleiben oder auch, anders als in Figur 7C dargestellt, bereits vor dem vollständigen Aushärten und/oder Vernetzen von dem Konversionsmittelkörper 5 entfernt werden, beispielsweise bevor oder unmittelbar nach dem Positionieren des Konversionsmittelkörpers 5 an der Halbleiterschichtenfolge 3.

Sofern die Trägerfolie 8 nicht bereits vor dem Aushärten entfernt wurde, wird diese nach dem vollständigen Aushärten von dem Konversionsmittelkörper 5 abgenommen, vergleiche Figur 7D.

In Figur 8 sind herkömmliche Halbleiterbauteile dargestellt, die ebenfalls einen Konversionsmittelkörper 5 umfassen. Gemäß Figur 8A ist der Konversionsmittelkörper 5, der insbesondere ein Silikon umfasst, über ein Verbindungsmittel 4 an der Halbleiterschichtenfolge 3 angebracht. Das Verbindungsmittel 4 ist zum Beispiel ein niederviskoser Silikonkleber. Im Gegensatz zu dem Konversionsmittelkörper 5 ist das Verbindungsmittel 4 in einem Spektralbereich, in dem die Halbleiterschichtenfolge 3 im Betrieb Strahlung erzeugt, transparent beziehungsweise klarsichtig.

Dadurch, dass das Verbindungsmittel 4 beim Aufbringen eine nur geringe Viskosität aufweist, kann beim Aufbringen des Konversionsmittelkörpers 5 in lateraler Richtung das Verbindungsmittel 4 teilweise die Flanken 34 der Halbleiterschichtenfolge 3 oder auch den Träger 2 benetzen. Eine solche Benetzung ist vermeidbar durch ein spezielles Design des Trägers 2 beziehungsweise der Halbleiterschichtenfolge 3 sowie durch besondere Reinigungsschritte des Trägers 2. Solche Maßnahmen erhöhen allerdings die Herstellungskosten. Dadurch, dass etwa gemäß den Figuren 1 bis 4 der Konversionsmittelkörper 5 verbindungsmittelfrei aufgebracht wird, besteht keine Gefahr einer Kontamination beispielsweise des Trägers 2 durch das Verbindungsmittel 4 und auf ein aufwändiges Design des Trägers 2 und/oder der Halbleiterschichtenfolge 3 kann verzichtet werden.

Gemäß Figur 8B ist der Konversionsmittelkörper 5 über ein Siebdruckverfahren direkt auf die Halbleiterschichtenfolge 3 aufgebracht. Ein solches Verfahren erfordert eine hohe Präzision und ist vergleichsweise kostenintensiv. Um den Konversionsmittelkörper 5 direkt auf dem Halbleiterchip 3 aufzubringen, weist ein Ausgangsmaterial und insbesondere auch der fertig gestellte Konversionsmittelkörper 5 nur eine vergleichsweise geringe Härte auf, insbesondere weniger als Shore A 80 oder weniger als Shore A 60.

Neben der Materiallimitation hinsichtlich der Härte bei einem Siebdruckverfahren direkt auf die Halbleiterschichtenfolge 3 ist auch eine Dicke des Konversionsmittelkörpers 5 im Vergleich zu einem Konversionsmittelkörper 5 gemäß den Figuren 1 bis 4 ungleichmäßiger gestaltet, wodurch lokale Farbortschwankungen einer wellenlängenkonvertierten Strahlung auftreten können. Ebenso wie bei der Verwendung eines Verbindungsmittels 4 besteht bei einem direkten Aufdrucken des Konversionsmittelkörpers 5 auf die Halbleiterschichtenfolge 3 die Gefahr einer Kontamination der Flanken 34 oder des Trägers 2 durch ein Material des Konversionsmittelkörpers 5.

## Patentansprüche

1. Anordnung mit einem Konversionsmittelkörper (5) für einen optoelektronischen Halbleiterchip (1), mit einer Trägerfolie (8) und mit einer Abdeckfolie (9), wobei
- der Konversionsmittelkörper (5) ein Matrixmaterial (50) und Konversionsmittelpartikel (55), die in das Matrixmaterial (50) eingebettet sind, umfasst,
- das Matrixmaterial (50) unvollständig ausgehärtet und/oder vernetzt ist, und
- der Konversionsmittelkörper (5) bei Raumtemperatur eine Härte zwischen einschließlich Shore A 0 und Shore A 35 und/oder eine Viskosität zwischen einschließlich 10 Pa·s und 150 Pa·s aufweist, und
- sich der Konversionsmittelkörper (5) zwischen der Trägerfolie (8) und der Abdeckfolie (9) befindet.

2. Anordnung nach dem vorhergehenden Anspruch,
bei der das Matrixmaterial (50) ein Silikon enthält oder ein Silikon ist.

3. Anordnung nach einem der vorhergehenden Ansprüche,
bei der das Matrixmaterial (50) thermisch vollständig vernetzbar und/oder aushärtbar ist und eine Aushärtzeit mindestens 10 min. beträgt.

4. Anordnung einem der vorhergehenden Ansprüche,
bei der der Konversionsmittelkörper (5) frei von einem Thixotropiermittel ist.

5. Anordnung nach einem der vorhergehenden Ansprüche,
bei der ein Gewichtsanteil der Konversionsmittelpartikel (55) zwischen einschließlich 20 % und 75 % liegt.

6. Anordnung nach dem vorhergehenden Anspruch,
bei der ein Gewichtsanteil der Konversionsmittelpartikel (55) zwischen einschließlich 55 % und 70 % liegt.

7. Anordnung nach einem der vorhergehenden Ansprüche,
bei der sich sowohl die Trägerfolie (8) als auch die Abdeckfolie (9) von dem Konversionsmittelkörper (5) entfernen lassen, ohne den Konversionsmittelkörper (5) zu beschädigen, solange das Matrixmaterial (50) nicht vollständig ausgehärtet ist.

8. Anordnung nach einem der vorhergehenden Ansprüche,
bei der die Trägerfolie (8) eine Ethylen-Tetrafluorethylen-Folie ist.

9. Anordnung nach einem der vorhergehenden Ansprüche,
bei der der Konversionsmittelkörper (5) bei einer Temperatur von 293 K eine Härte zwischen einschließlich Shore A 2 und Shore A 15 aufweist.

10. Verfahren zur Herstellung eines optoelektronischen Halbleiterchips (1) mit den Schritten:
- Bereitstellen einer Halbleiterschichtenfolge (3) mit mindestens einer aktiven Schicht,
- Bereitstellen eines einstückigen Konversionsmittelkörpers (5) mit einem Matrixmaterial (50), in das Konversionsmittelpartikel (55) eingebettet sind, wobei das Matrixmaterial (50) unvollständig vernetzt und/oder ausgehärtet ist, und wobei der Konversionsmittelkörper (5) bei Raumtemperatur eine Härte zwischen einschließlich Shore A 0 und Shore A 35 und/oder eine Viskosität zwischen einschließlich 10 Pa·s und 150 Pa·s aufweist,
- Aufbringen des Konversionsmittelkörpers (5) auf die Halbleiterschichtenfolge (3), so dass diese in direktem Kontakt zueinander stehen, und
- Aushärten des Konversionsmittelkörpers (5), wobei nach dem Aushärten die Härte des Konversionsmittelkörpers (5) mindestens Shore A 30 und höchstens Shore D 80 beträgt.

11. Verfahren nach dem vorhergehenden Anspruch,
wobei der Konversionsmittelkörper (5) auf einer Trägerfolie (8) aufgebracht und von einer Abdeckfolie (9) überdeckt ist, und wobei zumindest die Trägerfolie (8) im ultravioletten und im blauen Spektralbereich mindestens teilweise strahlungsdurchlässig ist.

## Claims

1. Arrangement comprising a conversion medium body (5) for an optoelectronic semiconductor chip (1), with a backing film (8) and covered by a covering film (9), wherein
- the conversion medium body (5) comprises a matrix material (50) and conversion medium particles (55), which are embedded in the matrix material (50),
- the matrix material (50) is incompletely cured and/or crosslinked, and
- at room temperature the conversion medium body (5) exhibits a hardness of between Shore A 0 and Shore A 35 inclusive and/or a viscosity of between 10 Pa·s and 150 Pa·s inclusive, and
- the conversion medium body (5) is arranged between the backing film (8) and the covering film (9).

2. Arrangement according to the preceding claim,
in which the matrix material (50) contains a silicone or is a silicone.

3. Arrangement according to any one of the preceding claims,
in which the matrix material (50) is thermally completely crosslinkable and/or curable and the curing time amounts to at least 10 min.

4. Arrangement according to any one of the preceding claims,
which does not contain a thixotroping agent.

5. Arrangement according to any one of the preceding claims,
in which the proportion by weight of the conversion medium particles (55) is between 20% and 75% inclusive.

6. Arrangement according to any one of the preceding claims,
in which the proportion by weight of the conversion medium particles (55) is between 20% and 75% inclusive, in particular between 55% and 70% inclusive.

7. Arrangement according to any one of the preceding claims,
in which the backing film (8) and the covering film (9) can be removed from the conversion medium body (5) without damaging the latter, as long as the matrix material (50) is not completely cured.

8. Arrangement according to any one of the preceding claims,
in which the backing film (8) is an ethylene-tetrafluoroethylene film.

9. Arrangement according to any one of the preceding claims,
in which a hardness of the conversion medium body (5) amounts to at least Shore A 2 and at most Shore A 15 at a temperature of 293 K.

10. A method of producing an optoelectronic semiconductor chip (1) with the steps:
- providing a semiconductor layer sequence (3) with at least one active layer,
- providing a one-piece conversion medium body (5) with a matrix material (50), in which are embedded conversion medium particles (55), wherein the matrix material (50) is incompletely crosslinked and/or cured, and wherein the conversion medium body (5) exhibits at room temperature a hardness of between Shore A 0 and Shore A 35 inclusive and/or a viscosity of between 10 Pa·s and 150 Pa·s inclusive,
- placing the conversion medium body (5) onto the semiconductor layer sequence (3), such that they are in direct contact with one another, and
- curing the conversion medium body (5), wherein after curing the hardness of the conversion medium body (5) amounts to at least Shore A 30 and at most Shore D 80.

11. A method according to the preceding claim,
wherein the conversion medium body (5) is placed on a backing film (8) and covered by a covering film (9), and wherein at least the backing film (8) is at least partially radiation-transmissive in the ultraviolet and in the blue spectral range.

## Revendications

1. Dispositif avec un corps à moyen de conversion (5) pour une puce à semi-conducteur optoélectronique (1), avec un film support (8) et avec un film de couverture (9),
dans lequel
- le corps à moyen de conversion (5) englobe un matériau matriciel (50) et des particules du moyen de conversion (55) logées dans le matériau matriciel (50),
- le matériau matriciel (50) n'est pas intégralement durci par vieillissement et/ou réticulé, et
- le corps à moyen de conversion (5) présente à température ambiante une dureté entre y compris A 0 et Shore A 35 et/ou une viscosité entre y compris 10 Pa•s et 150 Pa•s, et
- le corps à moyen de conversion (5) se trouve entre le film support (8) et le film de couverture (9).

2. Dispositif selon la revendication précédente, dans lequel le matériau matriciel (50) contient une silicone ou est une silicone.

3. Dispositif selon l'une des revendications précédentes,
dans lequel le matériau matriciel (50) est intégralement réticulable et/ou durcissable par vieillissement thermiquement et une durée de durcissement atteint au minimum 10 minutes.

4. Dispositif selon l'une des revendications précédentes,
dans lequel le corps à moyen de conversion (5) est exempt d'agent thixotrope.

5. Dispositif selon l'une des revendications précédentes,
dans lequel une proportion en poids des particules du moyen de conversion (55) se situe entre y compris 20 % et 75 %.

6. Dispositif selon la revendication précédente,
dans lequel une proportion en poids des particules du moyen de conversion (55) se situe entre y compris 55 % et 70 %.

7. Dispositif selon l'une des revendications précédentes,
dans lequel à la fois le film support (8) et le film de couverture (9) se laissent enlever du corps à moyen de conversion (5) sans endommager le corps à moyen de conversion (5) tant que le matériau matriciel (50) n'est pas intégralement durci par vieillissement.

8. Dispositif selon l'une des revendications précédentes,
dans lequel le film support (8) est un film en éthylène-tétrafluoréthylène.

9. Dispositif selon l'une des revendications précédentes,
dans lequel le corps à moyen de conversion (5) présente, à une température de 293 K, une dureté entre y compris Shore A 2 et Shore A 15.

10. Procédé de fabrication d'une puce à semi-conducteur optoélectronique (1) avec les étapes de :
- mise à disposition d'une suite de couches semi-conductrices (3) avec au moins une couche active,
- mise à disposition d'un corps à moyen de conversion en une seule pièce (5) avec un matériau matriciel (50) dans lequel des particules du moyen de conversion (55) sont logées, dans lequel le matériau matriciel (50) n'est pas intégralement réticulé et/ou durci par vieillissement et dans lequel le corps à moyen de conversion (5) présente, à température ambiante, une dureté entre y compris Shore A 0 et Shore A 35 et/ou une viscosité entre y compris 10 Pa•s et 150 Pa•s,
- mise en place du corps à moyen de conversion (5) sur la suite de couches semi-conductrices (3), de sorte que celles-ci soient en contact direct l'une avec l'autre, et
- durcissement par vieillissement du corps à moyen de conversion (5), dans lequel, après durcissement par vieillissement, la dureté du corps à moyen de conversion (5) atteint au minimum Shore A 30 et au maximum Shore D 80.

11. Procédé selon la revendication précédente,
dans lequel le corps à moyen de conversion (5) est mis en place sur un film support (8) et recouvert par un film de couverture (9) et dans au moins le film support (8) est au moins partiellement perméable au rayonnement dans la région spectrale ultraviolette et bleue.
